# EUROPEAN PATENT APPLICATION

(11) **EP 1 592 058 A2**
(43) Date of publication of application: **02.11.2005**
(21) Application number: 05008775.8
(22) Date of filing: 21.04.2005
(51) Int. Cl.: H01L 21/68, H01L 21/00

(54) **Method of selective thermal release from a heat peelable sheet and corresponding apparatus**

(30) Priority: 21.04.2004 JP 2004125331
(71) Applicant: NITTO DENKO CORPORATION, Osaka (JP)
(72) Inventor: Doi, Tomoko, Ibaraki-shi, Osaka (JP); Tanimoto, Masakazu, Ibaraki-shi, Osaka (JP); Arimitsu, Yukio, Ibaraki-shi, Osaka (JP); Shimokawa, Daisuke, Ibaraki-shi, Osaka (JP); Kawanishi, Michirou, Ibaraki-shi, Osaka (JP)
(74) Representative: Grünecker, Kinkeldey, Stockmair & Schwanhäusser Anwaltssozietät

(57) **Abstract**

The present invention intends to provide a method of thermal adherend release by which, when part of adherends (15) on a heat-peelable pressure-sensitive adhesive sheet (12) are desired to be thermally released therefrom, the desired part only can be easily and speedily released.

A method of thermal adherend release, wherein part of adherends (15) adherent to a heat-peelable pressure-sensitive adhesive sheet (12) having a heat-expandable layer (13) containing a foaming agent are selectively released from the pressure-sensitive adhesive sheet, wherein the method comprises partly heating the heat-peelable pressure-sensitive adhesive sheet (13) in an atmosphere having a temperature of 50°C or higher at which the heat-expandable layer does not expand to thereby selectively release the adherends (15).

## Description

### FIELD OF THE INVENTION

The present invention relates to a method by which part of adherends adherent to a heat-peelable pressure-sensitive adhesive sheet having a heat-expandable layer are selectively released therefrom thermally. The invention further relates to an apparatus for thermal adherend release for use in the method.

### BACKGROUND ART

Examples of methods by which parts bonded to a pressure-sensitive adhesive tape are released from the pressure-sensitive adhesive tape after a processing include a technique in which the substrate is caused to contract to pick up semiconductor chips obtained through dicing (see patent document 1). However, it is difficult for this technique, which is based only on substrate contraction, to reduce the adhesive force between the diced semiconductor chips and the pressure-sensitive adhesive tape to such a degree that the semiconductor chips canbe easilypickedup. It is also difficult to cause the substrate to evenly contract in the machine direction and the transverse direction. There has hence been a problem that semiconductor chips suffer positional shifting and come into contact with adjacent semiconductor chips, resulting in semiconductor chip breakage.

A heat-peelable pressure-sensitive adhesive sheet having a heat-expandable layer containing a foaming agent such as, e.g., heat-expandable microspheres (e.g., trade names "Revalpha" and "Revaclean" both manufactured by Nitto Denko Corp.) is used in various applications in various fields so as to eliminate those problems. This heat-peelable pressure-sensitive adhesive sheet has the following advantages. Adherends bonded and fixed to the pressure-sensitive adhesive sheet can be subjected, in this state, to a desired processing. After the processing, the foaming agent, e.g., heat-expandable microspheres, contained in the heat-expandable layer is expanded by heating to thereby reduce or eliminate the adhesive force of the heat-peelable pressure-sensitive adhesive sheet. Thus, the adherends adherent to the heat-peelable pressure-sensitive adhesive sheet can be easily released therefrom.

When adherends adherent to such a heat-peelable pressure-sensitive adhesive sheet are desired to be released therefrom, the whole pressure-sensitive adhesive sheet having the adherends adherent thereto is generally heat-treated to release all the adherends at a time. Recently, however, there is a growing desire to conduct thermal release in such a manner that only part of the adherends adherent to a heat-peelable pressure-sensitive adhesive sheet are released from the pressure-sensitive adhesive sheet and the remaining adherends are kept adherent to the heat-peelable pressure-sensitive adhesive sheet.

Forexample, steps for processing an FPC (flexible printed circuit) part obtained by laminating a thin copper foil to a polyimide film include a step in which the part is bonded and fixed to a heat-peelable pressure-sensitive adhesive sheet and cut in this state and the heat-peelable pressure-sensitive adhesive sheet is then heat-treated to move and separate part of the cut pieces of the part. In this operation, there has been a trouble that the vibration caused by the movement and separation of part of the cut pieces results in the deformation or shedding of other cut pieces. Furthermore, the step of dicing a semiconductor wafer or multilayer capacitor has had problems, for example, that when the heat-peelable pressure-sensitive adhesive sheet is heated after dicing in order to release parts held thereon, all the parts including the parts desired to be kept held are separated undesirably, and that the vibration caused by the movement and separation of parts after the processing results in the positional shifting or shedding of parts.

Under these circumstances, the present inventors proposed a method of thermal adherend release by which, when part of adherendson a heat-peelable pressure-sensitive adhesive sheet having a heat-expandable layer are desired to be thermally released therefrom, the desired part only can be easily released and the remaining adherends can be kept adherent to the heat-peelable pressure-sensitive adhesive sheet (see patent document 2).
[Patent Document 1]
JP-A-11-3875
[Patent Document 2]
JP-A-2002-322436

### SUMMARY OF THE INVENTION

In recent years, however, there is a desire for a method by which part of adherends adherent to a heat-peelable pressure-sensitive adhesive sheet can be selectively released from the heat-peelable pressure-sensitive adhesive sheet even more speedily from the standpoint of productivity.

Accordingly, an object of the invention is to provide a method and apparatus for thermal adherend release by which, when part of adherends on a heat-peelable pressure-sensitive adhesive sheet are desired to be thermally released therefrom, the desired part only can be easily released more speedily and the remaining adherends can be kept adherent to the heat-peelable pressure-sensitive adhesive sheet.

Another object of the invention is to provide a method and apparatus for thermal adherend release by which adherends on a heat-peelable pressure-sensitive adhesive sheet, during a processing, can be held thereon without shedding and, after the processing, desired part of the adherends can be easily and more speedily released from the heat-peelable pressure-sensitive adhesive sheet without causing damage or positional shifting to the adherends.

The present inventors made intensive investigations in order to accomplish those objects. As a result, it has been found that part of adherends adherent to a heat-peelable pressure-sensitive adhesive sheet can be selectively released therefrom by heating the heat-peelable pressure-sensitive adhesive sheet with a heater for partial heating in an atmosphere having a specific temperature. The invention has been completed based on this finding.

The invention provides a method of thermal adherend release in which part of adherends adherent to a heat-peelable pressure-sensitive adhesive sheet having a heat-expandable layer containing a foaming agent are selectively released from the pressure-sensitive adhesive sheet, the method comprising partly heating the heat-peelable pressure-sensitive adhesive sheet in an atmosphere having a temperature of 50°C or higher at which the heat-expandable layer does not expand to thereby selectively release the adherends.

The foaming agent preferably comprises heat-expandable microspheres. It is preferred that a heater capable of partly heating the heat-peelable pressure-sensitive adhesive sheet according to the shape of each adherend to be released should be used to heat those areas in the heat-peelable pressure-sensitive adhesive sheet in which the adherends to be released are adherent to thereby selectively release the adherends. In the invention, the heat-peelable pressure-sensitive adhesive sheet can be heated from at least one side selected between the side to which the adherends are adherent and the side opposite thereto.

The invention further provides a method of thermal adherend release in which part of adherends adherent to a heat-peelable pressure-sensitive adhesive sheet having a heat-expandable layer containing a foaming agent are selectively released from the pressure-sensitive adhesive sheet, the method comprising a step in which an adherend adherent to the heat-peelable pressure-sensitive adhesive sheet is cut into pieces and a step in which the heat-peelable pressure-sensitive adhesive sheet is partly heated in an atmosphere having a temperature of 50°C or higher at which the heat-expandable layer does not expand to thereby selectively release part of the cut pieces.

The invention furthermore provides an apparatus for thermal adherend release which is for separating adherends from a heat-peelable pressure-sensitive adhesive sheet having a heat-expandable layer containing a foaming agent, the apparatus having a heating part for partly heating the heat-peelable pressure-sensitive adhesive sheet in an atmosphere having a temperature of 50°C or higher at which the heat-expandable layer does not expand to thereby selectively release part of the adherends.

The heating part preferably has a shape which enables the heating part to heat the heat-peelable pressure-sensitive adhesive sheet according to the shape of each adherend to be released. The heating part may have been disposed on at least one side of the heat-peelable pressure-sensitive adhesive sheet selected between the side to which the adherends are adherent and the side opposite thereto. Furthermore, the heating part preferably is movable in a horizontal direction and/or a vertical direction.

The apparatus for thermal adherend release of the invention preferably has: a cutting part by which an adherend adherent to a heat-peelable pressure-sensitive adhesive sheet having a heat-expandable layer containing a foaming agent is cut into pieces; and a heating part for partly heating the heat-peelable pressure-sensitive adhesive sheet in an atmosphere having a temperature of 50°C or higher at which the heat-expandable layer does not expand to thereby selectively release part of the cut pieces.

According to the method of thermal adherend release of the invention, when part of adherends on a heat-peelable pressure-sensitive adhesive sheet are desired to be thermally released therefrom, the desired part only can be easily released more speedily and the remaining adherends can be kept adherent to the heat-peelable pressure-sensitive adhesive sheet. Furthermore, adherends on the heat-peelable pressure-sensitive adhesive sheet, during a processing, can be held thereon without shedding and, after the processing, desiredpart of the adherends can be easily and more speedily separated from the heat-peelable pressure-sensitive adhesive sheet without causing damage or positional shifting to the adherends.

Consequently, according to the apparatus for thermal adherend release of the invention, even in the case of finer and thinner adherends, the adherends during a processing can be satisfactorilyheldwithout shedding and, after the processing, the desired part only of the adherends can be easily, precisely, and speedily released from the pressure-sensitive adhesive sheet. Consequently, the adherends can be inhibited or prevented from suffering damage or a trouble such as positional shifting. A decrease in productivity, yield; etc. can hence be effectively prevented.

### BRIEF DESCRIPTION OF THE DRAWINGS

Fig. 1 is a diagrammatic sectional view showing one example of heat-peelable pressure-sensitive adhesive sheets usable in the method of thermal adherend release of the invention.
Fig. 2 is a diagrammatic view showing part of one embodiment of the apparatus for thermal adherend release of the invention.

The Signs in the drawings are described as follows:
- 1: heat-peelable pressure-sensitive adhesive sheet
- 2: supporting substrate
- 3: rubbery organic elastic layer
- 4: heat-expandable pressure-sensitive adhesive layer
- 5: separator (release liner)
- 6: heating/release part in apparatus for thermal adherend release
- 7: heating part
- 7a: surface part of heating part 7
- 8: suction nozzle
- 9: fixing ring
- 10: die bonder
- 11: heat source
- 12: heat-peelable pressure-sensitive adhesive sheet
- 13: heat-expandable pressure-sensitive adhesive layer
- 13a: unexpanded area in heat-expandable pressure-sensitive adhesive layer 13
- 13b: 13b expanded area in heat-expandable pressure-sensitive adhesive layer 13
- 14: substrate
- 15: adherend
- 15a: adherend released

### DETAILED DESCRIPTION OF THE INVENTION

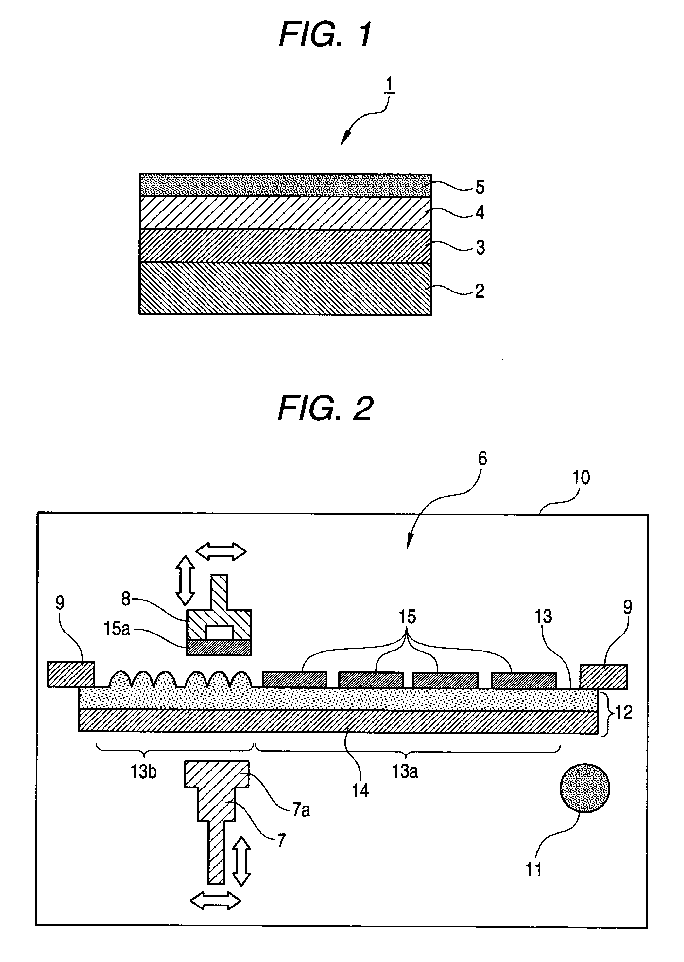

Modes for carrying out the invention will be explained below in detail by reference to the drawings according to need. Fig. 1 is a diagrammatic sectional view illustrating one example of heat-peelable pressure-sensitive adhesive sheets usable in the method of thermal adherend release of the invention. In Fig. 1, numeral 1 denotes a heat-peelable pressure-sensitive adhesive sheet, 2 a supporting substrate, 3 a rubbery organic elastic layer, 4 a heat-expandable pressure-sensitive adhesive layer, and 5 a separator (release liner). The heat-peelable pressure-sensitive adhesive sheet 1 shown in Fig. 1 has a constitution comprising a supporting substrate 2, a heat-expandable pressure-sensitive adhesive layer 4 formed on one side of the substrate 2 through a rubbery organic elastic layer 3, and a separator 5 superposed on the heat-expandable pressure-sensitive adhesive layer 4.

### (Heat-Peelable Pressure-Sensitive Adhesive Sheet)

The heat-peelable pressure-sensitive adhesive sheet in the invention at least has a heat-expandable layer containing a foaming agent. This heat-peelable pressure-sensitive adhesive sheet may have a constitution including a heat-expandable pressure-sensitive adhesive layer, which serves as both a heat-expandable layer and a pressure-sensitive adhesive layer, as shown in Fig. 1, or may have a constitution which comprises a heat-expandable layer and a pressure-sensitive adhesive layer as separate layers. Consequently, the heat-expandable layer containing a foaming agent may have the function of a pressure-sensitive adhesive layer.

In the case where the heat-expandable layer is such a heat-expandable pressure-sensitive adhesive layer which functions also as a pressure-sensitive adhesive layer, the heat-peelable pressure-sensitive adhesive sheet need not have a pressure-sensitive adhesive layer and the surface of the heat-expandable pressure-sensitive adhesive layer can be utilized as the pressure-sensitive adhesive side to which adherends are bonded.

On the other hand, in the case where the heat-expandable layer does not function as a pressure-sensitive adhesive layer, the heat-peelable pressure-sensitive adhesive sheet should have a pressure-sensitive adhesive layer and the surface of this pressure-sensitive adhesive layer can be utilized as the pressure-sensitive adhesive side to which adherends are bonded. This pressure-sensitive adhesive layer can be formed on the heat-expandable layer.

Although the heat-peelable pressure-sensitive adhesive sheet 1 shown in Fig. 1 has a rubbery organic elastic layer 3 and a separator 5, the rubbery organic elastic layer 3 and the separator 5 are optional. It is preferred that the pressure-sensitive adhesive sheet 1 shouldhave a rubbery organic elastic layer from the standpoints of, e.g., attaining an improved anchoring force and forming an undulation when the heat-expandable layer, e.g., heat-expandable pressure-sensitive adhesive layer, is thermally expanded. Furthermore, use of a separator is preferred from the standpoint of protecting the pressure-sensitive adhesive side of the heat-expandable pressure-sensitive adhesive layer. However, it is possible to subject the back side of the substrate to a releasant treatment to thereby protect the pressure-sensitive adhesive side of the heat-expandable pressure-sensitive adhesive layer with the back side of the substrate.

### (Heat-Expandable Layer)

The heat-expandable layer contains a foaming agent for imparting thermal expansibility. This layer hence functions by the following mechanism. When the heat-peelable pressure-sensitive adhesive sheet which has adherends adherent to the pressure-sensitive adhesive side is partly heated at any desired time, the foaming agent present in those areas in the heat-expandable layer which have been thus heated selectively is caused to blow and/or expand and the heat-expandable layer partly expands accordingly. Due to this partial expansion of the heat-expandable layer, those areas in the pressure-sensitive adhesive side which correspond to the expanded parts deform so as to have surface irregularities, resulting in a reduced area of adhesion between the pressure-sensitive adhesive side and the adherends. As a result, the adhesive force between the pressure-sensitive adhesive side deformed so as to have surface irregularities and the adherends is reduced and the adherends adherent to this pressure-sensitive adhesive side can be released from the heat-peelable pressure-sensitive adhesive sheet.

The foaming agent used in the heat-expandable layer is not particularly limited. However, it is preferred to use heat-expandable microspheres. Foaming agents may be used alone or in combination of two or more thereof. The heat-expandable microspheres are not particularly limited and can be suitably selected from known heat-expandable microspheres (e.g., various inorganic heat-expandable microspheres and organic heat-expandable microspheres). The heat-expandable microspheres to be use preferably are amicroencapsulated foaming agent from the standpoints of, e.g., ease of mixing operation. Examples of such heat-expandable microspheres include microspheres obtained by encapsulating a substance which readily gasifies and expands upon heating, such as, e.g., isobutane, propane, or pentane, in elastic shells. In many cases, the shells are formed from a heat-fusible material or a material which breads upon thermal expansion. Examples of materials usable for forming the shells include vinylidene chloride/acrylonitrile copolymers, poly(vinyl alcohol), poly(vinyl butyral), poly(methyl methacrylate), polyacrylonitrile,poly(vinylidene chloride),and polysulfones. Heat-expandable microspheres can be produced by methods in ordinary use, such as, e.g., the coacervation method and interfacial polymerization method. There also are commercial products of heat-expandable microspheres, such as, e.g., trade name "Matsumoto Microsphere" [manufactured by Matsumoto Yushi-Seikayku Co., Ltd.].

Foaming agents other than heat-expandable microspheres can be used as the foaming agent in the invention. Such a foaming agent suitably selected from various foaming agents including various inorganic foaming agents and organic foaming agents can be used. Typical examples of the inorganic foaming agents include ammonium carbonate, ammonium hydrogen carbonate, sodium hydrogen carbonate, ammonium nitrite, sodium boron hydroxide, and various azides. Typical examples of the organic foaming agents include water; chlorofluoroalkane compounds such as trichloromonofluoromethane and dichloromonofluoromethane; azo compounds such as azobisisobutyronitrile, azodicarbonamide, and barium azodicarboxylate; hydrazine compounds such as p-toluenesulfonylhydrazide, diphenyl sulfone 3,3'-disulfonylhyrdazide, 4,4'-oxybis(benzenesulfonylhydrazide), and allylbis(sulfonylhydrazide); semicarbazide compounds such as p-toluylenesulfonylsemicarbazide and 4,4'-oxybis(benzenesulfonylsemicarbazide); triazole compounds such as 5-morpholyl-1,2,3,4-thiatriazole; and N-nitroso compounds such as N,N'-dinitrosopentamethylenetetramine and N,N'-dimethyl-N,N'-dinitrosoterephthalamide.

In the invention, it is preferred to use a foaming agent which has such moderate strength that it does not break until it expands 5 times ormore, preferably 7 times or more, especially 10 times or more, for the purpose of efficiently and stably reducing the adhesive force of the heat-expandable layer by a heat treatment.

The amount of the foaming agent (e.g., heat-expandable microspheres) to be incorporated can be suitably determined according to the desired expansion ratio and the desired degree of adhesive force reduction of the heat-expandable layer, etc. In general, however, the amount thereof is, for example, 1-150 parts by weight, preferably 10-130 parts by weight, more preferably 25-100 parts by weight, per 100 parts by weight of the base polymer constituting the heat-expandable layer.

In the case where heat-expandable microspheres are used as the foaming agent, the particle diameter (average particle diameter) of the heat-expandable microspheres can be suitably selected according to the thickness of the heat-expandable layer, etc. The average particle diameter of the heat-expandable microspheres can be selected in the range of, for example, up to 100 µm (preferably up to 80 µm, more preferably 1-50 µm, especially 1-30 µm). The particle diameter of the heat-expandable microspheres may have been regulated in the course of production of the heat-expandable microspheres, or may be regulated by a technique such as, e.g., classification after production. The heat-expandable microspheres preferably are uniform in particle diameter.

The heat-expandable layer may be any layer containing a foaming agent. For example, the heat-expandable layer may be a layer comprising a viscoelastic material and a foaming agent dispersed therein (heat-expandable viscoelastic layer). Such a heat-expandable elastic layer can be formed from a foaming-agent-containing viscoelastic composition comprising a viscoelastic material and, incorporated therein, a foaming agent for imparting thermal expansibility. It is important that the viscoelasticity of the viscoelastic material should be in such a degree that the viscoelastic material does not inhibit the foaming agent from foaming and/or expanding upon a heat treatment. Namely, as the viscoelastic material can be used at least one viscoelastic material which does not inhibit the thermal expansion of the foaming agent. As such a viscoelastic material can be used, for example, a rubber, resin, or pressure-sensitive adhesive which has moderate viscoelasticity which permits the foaming agent to blow and/or expand upon heating. Examples of the viscoelastic material include rubbers, thermosetting resins, thermoplastic resins, pressure-sensitive adhesives, resins curable with energy rays, and pressure-sensitive adhesives curable with energy rays. Such viscoelastic materials can be used alone or in combination of two or more thereof.

More specific examples of the viscoelastic material are as follows. Examples of the rubbers include various rubbers such as natural rubber, synthetic rubbers, and silicone rubbers. Examples of the thermosetting resins include epoxy resins, unsaturated ester resins, thermosetting acrylic resins, and phenolic resins. Examples of the thermoplastic resins include saturated polyester resins, thermoplastic polyurethane resins, amide resins,imide resins,thermoplastic acrylic resins,olefin resins, and vinyl acetate resins.

Examples of the pressure-sensitive adhesives include various pressure-sensitive adhesives such as rubber-based pressure-sensitive adhesives, acrylic pressure-sensitive adhesives, silicone pressure-sensitive adhesives, vinylalkyl ether-based pressure-sensitive adhesives, polyester-based pressure-sensitive adhesives, polyamide-based pressure-sensitive adhesives, urethane-based pressure-sensitive adhesives, and fluoropolymer-based pressure-sensitive adhesives.

Examples thereof further include known pressure-sensitive adhesives such as a pressure-sensitive adhesive with improved creep characteristics produced by incorporating a heat-fusible resin having a melting point of about 200°C or lower into any of those pressure-sensitive adhesives (see, for example, JP-A-56-61468, JP-A-61-174857, JP-A-63-17981, and JP-A-56-13040).

Preferredpressure-sensitive adhesives are rubber-based pressure-sensitive adhesives and acrylic pressure-sensitive adhesives. In particular, acrylic pressure-sensitive adhesives are preferred. Examples of the rubber-based pressure-sensitive adhesives include rubber-based pressure-sensitive adhesives comprising natural rubber or any of various synthetic rubbers [e.g., polyisoprene rubber, styrene/butadiene block copolymer (SB) rubbers, styrene/isoprene block copolymer (SI) rubbers, styrene/isoprene/styrene block copolymer (SIS) rubbers, styrene/butadiene/styrene block copolymer (SBS) rubbers, styrene/isoprene/butadiene/styrene block copolymer (SIBS) rubbers, styrene/ethylene/butylene/styrene block copolymer (SEBS) rubbers, styrene/ethylene/propylene/styrene block copolymer (SEPS) rubbers, styrene/ethylene/propylene block copolymer (SEP) rubbers, regenerated rubbers, butyl rubber, polyisobutylene, and modifications of these] as the base polymer.

Examples of the acrylic pressure-sensitive adhesives include acrylic pressure-sensitive adhesives comprising an acrylic polymer formed from one or more monomer ingredients comprising one or more alkyl (meth)acrylates [homopolymer or copolymer] as the base polymer. Examples of the alkyl (meth)acrylates for use in producing the acrylic pressure-sensitive adhesives include C₁₋₂₀ alkyl esters of (meth)acrylic acid, such as methyl (meth)acrylate, ethyl (meth)acrylate, propyl (meth)acrylate, isopropyl (meth)acrylate, butyl (meth) acrylate, isobutyl (meth) acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate nonyl (meth) acrylate, isononyl (meth) acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate [preferably, C₄₋₁₈ alkyl (linear or branched alkyl) esters of (meth) acrylic acid].

The acrylic polymer may contain, according to need, units derived from one or more other monomer ingredients copolymerizable with the alkyl (meth)acrylates so as to be modified in cohesive force, heat resistance, crosslinkability, etc. Examples of such monomer ingredients include carboxyl-containing monomers such as acrylic acid, methacrylic acid, itaconic acid, maleic acid, fumaric acid, crotonic acid, and carboxyethyl acrylate; monomers containing an acid anhydride group, such as maleic anhydride and itaconic anhydride; hydroxyl-containing monomers such as hydroxyethyl (meth) acrylate, hydroxypropyl (meth) acrylate, and hydroxybutyl (meth)acrylate; (N-substituted or unsubstituted) amide monomers such as (meth)acrylamide, N,N-dimethyl(meth)acrylamide, N-butyl(meth)acrylamide, N-methylol(meth)acrylamide, and N-methylolpropane (meth) acrylamide; vinyl ester monomers such as vinyl acetate and vinyl propionate; styrene monomers such as styrene and α-methylstyrene; vinyl ether monomers such as vinyl methyl ether and vinyl ethyl ether; cyanoacrylate monomers such as acrylonitrile and methacrylonitrile; acrylic monomers containing an epoxy group, such as glycidyl (meth)acrylate; olefin or diene monomers such as ethylene, propylene, isoprene, butadiene, and isobutylene; (substituted or unsubstituted) amino-containing monomers such as aminoethyl (meth)acrylate, N,N-dimethylaminoethyl (meth)acrylate, and t-butylaminoethyl (meth)acrylate; alkoxyalkyl (meth)acrylate monomers such as methoxyethyl (meth)acrylate and ethoxyethyl (meth)acrylate; monomers having a ring containing one or more nitrogen atoms, such as N-vinylpyrrolidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-vinylmorpholine, and N-vinylcaprolactam; N-vinylcarboxamides; sulfo-containing monomers such as styrenesulfonic acid, allylsulfonic acids, (meth)acrylamidopropanesulfonic acid, and sulfopropyl (meth)acrylate; monomers containing a phosphate group, such as 2-hydroxyethyl acryloylphosphate; maleimide monomers such as N-cyclohexylmaleimide, N-isopropylmaleimide, N-laurylmaleimide, andN-phenylmaleimide; itaconimidemonomers such as N-methylitaconimide, N-ethylitaconimide, N-butylitaconimide, N-octylitaconimide, N-2-ethylhexylitaconimide, N-cyclohexylitaconimide, and N-laurylitaconimide; succinimide monomers such as N-(meth)acryloyloxymethylenesuccinimide, N-(meth)acryloyl-6-oxyhexamethylenesuccinimide, and N-(meth)acryloyl-8-oxyoctamethylenesuccinimide; glycol acrylate monomers such as polyethylene glycol (meth)acrylate and polypropylene glycol (meth)acrylate; monomers having a heterocycle containing one or more oxygen atoms, such as tetrahydrofurfuryl (meth)acrylate; acrylic ester monomers containing one or more fluorine atoms, such as fluorinated (meth) acrylates; acrylic ester monomers containing one or more silicon atoms, such as silicone (meth)acrylates; and polyfunctional monomers such as hexanediol di(meth)acrylate, (poly) ethylene glycol di (meth) acrylate, (poly) propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylates, polyester acrylates, urethane acrylates, divinylbenzene, butyl di(meth)acrylate, and hexyl di(meth)acrylate. These monomer ingredients can be used alone or in combination of two or more thereof.

From the standpoint of abalance betweenmoderate adhesive force before a heat treatment and the property of deceasing in adhesive force through the heat treatment, a more preferred pressure-sensitive adhesive is one which comprises as the base a polymer whose dynamic modulus as measured at any temperature in the range of ordinary temperature to 150°C is in the range of 5,000 to 1,000,000 (Pa).

The pressure-sensitive adhesive may contain suitable additives besides polymer ingredients such as the pressure-sensitive adhesive ingredient (base polymer) and the like according to the kind of the pressure-sensitive adhesive, etc. Examples of the additives include crosslinking agents (e.g., isocyanate crosslinking agents, epoxy crosslinking agents, and melamine crosslinking agents), tackifiers (e.g., ones which are solid, semisolid, or liquid at ordinary temperature and comprise a rosin derivative resin, polyterpene resin, petroleum resin, oil-soluble phenolic resin, or the like), plasticizers, fillers, antioxidants, and surfactants.

It is especially preferred to use a pressure-sensitive adhesive as the viscoelastic material. By thus using a pressure-sensitive adhesive as the viscoelastic material, a heat-expandable pressure-sensitive adhesive layer can be formed as the heat-expandable layer. Namely, the heat-expandable pressure-sensitive adhesive layermaybe constitutedof a foaming agent for imparting thermal expansibility and a pressure-sensitive adhesive for imparting pressure-sensitive adhesive properties.

The heat-expandable pressure-sensitive adhesive layer can be formed, for example, in an ordinary manner in which a pressure-sensitive adhesive is mixed with a foaming agent (e.g., heat-expandable microspheres) and optionally with a solvent and other additives and the resultant mixture is formed into a sheet-form layer. Specifically, the heat-expandable pressure-sensitive adhesive layer can be formed, for example, by a method in which a mixture comprising a pressure-sensitive adhesive and a foaming agent (e.g., heat-expandable microspheres) and optionally containing a solvent and other additives is applied to a substrate or to the rubbery organic elastic layer which will be described later or a method in which the mixture is applied to an appropriate separator (e.g., release paper) to form a heat-expandable pressure-sensitive adhesive layer and this layer is transferred (moved) to a substrate or to the rubbery organic elastic layer. For application for forming the heat-expandable pressure-sensitive adhesive layer, use can be made of an apparatus for use in spin coating or in general coating machines for pressure-sensitive adhesives (e.g., fountain coater or kiss coater). The heat-expandable pressure-sensitive adhesive layer may have a single-layer or multilayer constitution.

It is a matter of course that when the heat-expandable layer is not a heat-expandable pressure-sensitive adhesive layer, this heat-expandable layer can be formed in the same manner as in the formation of the heat-expandable pressure-sensitive adhesive layer described above.

The thickness of the heat-expandable layer (e.g., heat-expandable pressure-sensitive adhesive layer) can be suitably selected according to the property of decreasing in adhesive force, etc. The thickness thereof is, for example, about 5-300 µm (preferably 20-150 µm). It is, however, important that when heat-expandable microspheres are contained as the foaming agent, the thickness of the heat-expandable layer be larger than the maximum particle diameter of the heat-expandable microspheres contained.

In case where the thickness of the heat-expandable layer is too small, this layer has impaired surface smoothness because of irregularities attributable to the heat-expandable microspheres, resulting in reduced adhesive force before heating (unexpanded state). Furthermore, this heat-expandable layer has a low degree of deformation by a heat treatment and is less apt to cause a smooth decrease in adhesive force. On the other hand, in case where the heat-expandable layer is too thick, this heat-expandable layer is apt to suffer a cohesive failure after the expansion or foaming by a heat treatment, resulting in cases where an adhesive residue remains on the adherend.

### (Substrate)

The heat-peelable pressure-sensitive adhesive sheet shown in Fig. 1 employs a supporting substrate (often referred to simply as "substrate"). Such a substrate can be used as a supporting base for the heat-expandable layer and other layers. As the substrate can be used an appropriate sheet material. Examples thereof include paper-based substrates such as paper; fibrous substrates such as woven fabrics, nonwoven fabrics, felts, and nets; metallic substrates such as metal foils and metal sheets; plastic substrates such as plastic films and sheets; rubber-based substrates such as rubber sheets; foams such as foamed sheets; and laminates of these (in particular, laminates of a plastic substrate with another kind of substrate and laminates of a plastic film (or sheet) with another plastic film (or sheet)). From the standpoint of handleability after heating, etc., the substrate preferably is one which has excellent heat resistance so as not to melt at the temperature to be used for the heat-treatment of the heat-expandable layer. It is preferred to use a plastic substrate such as a plastic film or sheet as the substrate. Examples of the material of the plastic film or sheet include olefin resins formed from one or more monomer ingredients including an α-olefin, such as polyethylene (PE), polypropylene (PP), ethylene/propylene copolymers, and ethylene/vinyl acetate copolymers (EVA); polyesters such as poly(ethylene terephthalate) (PET), poly(ethylene naphthalate) (PEN), and poly(butylene terephthalate) (PBT); poly(vinyl chloride) (PVC); poly(phenylene sulfide) (PPS); amide resins such as polyamides (nylons) and wholly aromatic polyamides (aramids); and polyetheretherketones (PEEK). These materials may be used alone or in combination of two or more thereof.

In the case where the substrate used is a plastic substrate, the deformability such as, e.g., stretchability of this substrate may have been regulated by a stretch treatment, etc. In the case where a radiation-curable material is used in the heat-expandable layer or another layer, it is preferred to use a substrate which does not inhibit the transmission of the radiation.

The thickness of the substrate can be suitably selected according to strength, flexibility, intended use, etc. For example, the thickness thereof is generally about 1,000 µm or smaller (e.g., 1-1,000 µm), preferably about 1-500 µm, more preferably about 3-300 µm, especially about 5-250 µm. However, the substrate thickness should not be construed as being limited to these. The substrate may have a single-layer constitution or a multilayer constitution.

In order for the substrate to have enhanced adhesion to an adjacent layer (e.g., the heat-expandable layer or rubbery organic elastic layer), the surface of the substrate may have undergone a common surface treatment, e.g., a chemical or physical oxidation treatment such as corona treatment, chromic acid treatment, exposure to ozone, exposure to a flame, exposure to a high-tension electric shock, or treatment with an ionizing radiation, or another treatment, e.g., a coating treatment with a primer. The substrate may have undergone a coating treatment with a release agent such as, e.g., a silicone resin or fluororesin for imparting releasability from the heat-expandable layer, etc.

The heat-expandable layer may be formed on at least one side (one side or each side) of the substrate. Aconstitution which includes a substrate embedded in the heat-expandable layer may be employed.

### (Interlayer)

The heat-peelable pressure-sensitive adhesive sheet of the invention may have one or more interlayers disposed between, e.g., the substrate and the heat-expandable layer. Examples of such interlayers include coating layers of a release agent which are intended to impart releasability and coating layers of a primer which are intended to improve adhesion. Examples of the interlayers other than the release agent coating layers and primer coating layers include layers for imparting satisfactory deformability, layers for increasing the area of adhesion to adherends (e.g., semiconductor wafers), layers for improving adhesive force, layers for improving conformability to the surface shape of adherends (e.g., semiconductor wafers), layers for improving the effect of thermally reducing adhesive force, and layers for improving releasabilityfromadherends (e.g., semiconductor wafers) after heating. From the standpoints of imparting deformability to the heat-peelable pressure-sensitive adhesive sheet, improving the releasability thereof after heating, etc., it is preferred to form a rubbery organic elastic layer as an interlayer between the substrate and the heat-expandable layer as shown in Fig. 1.

In the heat-peelable pressure-sensitive adhesive sheet 1 shown in Fig. 1, the heat-expandable pressure-sensitive adhesive layer 4 as a heat-expandable layer has been formed over the supporting substrate (substrate) 2 through a rubbery organic elastic layer 3. By thus disposing a rubbery organic elastic layer, the surface of the heat-peelable pressure-sensitive adhesive sheet which is being applied to an adherend can be made to satisfactorily conform to the surface shape of the adherend to attain an increased adhesion area. In addition, when this heat-peelable pressure-sensitive adhesive sheet is heated for release from the adherend, the thermal expansion of the heat-expandable layer can be highly (precisely) controlled and the heat-expandable layer can be evenly expanded preferentially in the thickness direction.

Namely, the rubbery organic elastic layer serves to enable the surface of the heat-peelable pressure-sensitive adhesive sheet which is being applied to an adherend to conform to the surface shape of the adherend and come to have an increased adhesion area, and further serves to help the formation of an undulation when the heat-expandable layer is thermally foamed and/or expanded in preparation for the release of the adherend from the heat-peelable pressure-sensitive adhesive sheet, by diminishing restrictions on the foaming and/or expansion occurring in plane directions for the heat-peelable pressure-sensitive adhesive sheet and thus enabling the heat-expandable layer to undergo a three-dimensional structural change.

Incidentally, the rubbery organic elastic layer is a layer to be formed according to need as stated above, and need not be always disposed. From the standpoint of enhancing the ability of adherends to be fixed for a processing and to be released after heating, it is preferred that the rubbery organic elastic layer is disposed.

It is preferred that the rubbery organic elastic layer be disposed so as to be superposed on the heat-expandable layer on the side thereof facing the substrate. The elastic layer may be formed as a layer other than the interlayer disposed between the substrate and the heat-expandable layer. The rubbery organic elastic layer may be disposed on one side or each side of the substrate.

The rubbery organic elastic layer is preferably made of natural rubber, a synthetic rubber, or a synthetic resin having rubber elasticity which each have a Shore D hardness, as measured in accordance with ASTM D-2240, of 50 or lower, especially 40 or lower. Examples of the synthetic rubber or synthetic resin having rubber elasticity include synthetic rubbers such as nitrile, diene, and acrylic rubbers; thermoplastic elastomers such as polyolefins and polyesters; and synthetic resins having rubber elasticity, such as ethylene/vinyl acetate copolymers, polyurethanes, polybutadiene, and flexible poly(vinyl chloride). Even in the case of polymers which intrinsically are rigid, like poly(vinyl chloride), they can have rubber elasticity when an ingredient such as a plasticizer or a softener is incorporated therein. Such compositions also can be used as materials for constituting the rubbery organic elastic layer. Furthermore, tacky materials such as the pressure-sensitive adhesive described above (e.g., rubber-based pressure-sensitive adhesive or acrylic pressure-sensitive adhesive) for constituting the heat-expandable pressure-sensitive adhesive layer can be used as materials for constituting the rubbery organic elastic layer.

The rubbery organic elastic layer can be formed, for example, by a method in which a coating fluid containing the material for forming a rubbery organic elastic layer, such as natural rubber, a synthetic rubber, or a synthetic resin having rubber elasticity, is applied to a substrate (coating method), a method in which either a film made of the material for forming a rubbery organic elastic layer or a multilayer film obtained beforehand by forming a layer of the material for forming a rubbery organic elastic layer on one or more heat-expandable pressure-sensitive adhesive layers is bonded to a substrate (dry laminating method), or a method in which a resin composition containing a material for constituting a substrate and a resin composition containing the material for forming a rubbery organic elastic layer are co-extruded

### (coextrusion method).

The rubbery organic elastic layer may be made of a tacky material comprising natural rubber, a synthetic rubber, or a synthetic resin having rubber elasticity as the main component. The layer may be constituted of a foamed film consisting mainly of such ingredient. Foaming can be conducted by an ordinary method, e.g., a method based on mechanical agitation, method in which a gas generated by reaction is utilized, method in which a foaming agent is used, method in which a soluble substance is removed, method based on spraying, method in which a syntactic foam is formed, or sintering method.

The thickness of the interlayer, e.g., the rubbery organic elastic layer is, for example, about 5-300 µm, preferably about 20-150 µm. When the interlayer is, for example, the rubbery organic elastic layer, too small thicknesses of the rubbery organic elastic layer make it impossible to cause a three-dimensional structural change through thermal foaming, resulting in cases where releasability is impaired. The interlayer, e.g., the rubbery organic elastic layer, may have a single-layer constitution or may be composed of two or more layers.

In the case where a radiation-curable material is used in the heat-expandable layer or another layer, it is preferred that the interlayer, e.g., the rubbery organic elastic layer, be one which does not inhibit the transmission of the radiation.

### (Separator)

In the heat-peelable pressure-sensitive adhesive sheet shown in Fig. 1, a separator (release liner) isusedasaprotective material for the heat-expandable pressure-sensitive adhesive layer as a heat-expandable layer. However, the separator need not be always disposed. In the case where a pressure-sensitive adhesive layer which is not a heat-expandable pressure-sensitive adhesive layer has been disposed, a separator (release liner) may have been disposed as a protective material for this pressure-sensitive adhesive layer.

The separator is stripped off when the pressure-sensitive adhesive layer protected with the separator is used (i.e., when an adherend is bonded to the pressure-sensitive adhesive layer protected with the separator).

As the separator can be used, for example, a release paper in common use. Examples of the separator include substrates having a release layer, such as plastic films and papers which have been surface-treated with a release agent such as a silicone, long-chain-alkyl, or fluorochemical release agent or molybdenum sulfide; lowly adhesive substrates made of fluoropolymers such as polytetrafluoroethylene, polychlorotrifluoroethylene, poly(vinyl fluoride), poly(vinylidene fluoride), tetrafluoroethylene/hexafluoropropylene copolymers, and chlorofluoroethylene/vinylidene fluoride copolymers; and lowly adhesive substrates made of nonpolar polymers such as polyolefin resins (e.g., polyethylene and polypropylene). A separator can be used also as a substrate for supporting the heat-expandable layer, e.g., the heat-expandable pressure-sensitive adhesive layer.

The separator can be formed by known or common methods. The separator is not particularly limited in thickness, etc.

### (Other Layers)

In the invention, the heat-peelable pressure-sensitive adhesive sheet is not particularly limited as long as it comprises a heat-expandable layer containing a foaming agent. For example, it may be a heat-peelable pressure-sensitive adhesive sheet having a substrate (substrate-based heat-peelable pressure-sensitive adhesive sheet) as shown in Fig. 1 or a heat-peelable pressure-sensitive adhesive sheet having no substrate (substrate-less heat-peelable pressure-sensitive adhesive sheet). In the case where the heat-peelable pressure-sensitive adhesive sheet is a substrate-based heat-peelable pressure-sensitive adhesive sheet, this pressure-sensitive adhesive sheet has a heat-expandable layer formed on at least one side of the substrate. Examples of this pressure-sensitive adhesive sheet include (1) a heat-peelable pressure-sensitive adhesive sheet of the type having a heat-expandable layer formedon one side of the substrate, (2) a heat-peelable pressure-sensitive adhesive sheet of the type having a heat-expandable layer formed on each side of the substrate, and (3) a heat-peelable pressure-sensitive adhesive sheet of the type having a heat-expandable layer formed on one side of the substrate and having a non-heat-expandable pressure-sensitive adhesive layer (pressure-sensitive adhesive layer not having thermal expansibility) on the other side of the substrate.

In the case where the heat-expandable layer is not a heat-expandable pressure-sensitive adhesive layer, it is important that the heat-peelable pressure-sensitive adhesive sheet be one which includes a non-heat-expandable pressure-sensitive adhesive layer formed over the heat-expandable layer. In this heat-peelable pressure-sensitive adhesive sheet, the surface of the non-heat-expandable pressure-sensitive adhesive layer disposed over the heat-expandable layer can be used as a pressure-sensitive adhesive side. On the other hand, in the case where the heat-expandable layer is a heat-expandable pressure-sensitive adhesive layer, the surface of this heat-expandable pressure-sensitive adhesive layer can be used as a pressure-sensitive adhesive side. Consequently, this adhesive sheet need not have a non-heat-expandable pressure-sensitive adhesive layer formed over the heat-expandable pressure-sensitive adhesive layer as a heat-expandable layer.

Such a non-heat-expandable pressure-sensitive adhesive layer (e.g., a non-heat-expandable pressure-sensitive adhesive layer to be formed on the heat-expandable layer and a non-heat-expandable pressure-sensitive adhesive layer to be formed on the substrate on the side thereof opposite to the heat-expandable layer) can be formed from any of the pressure-sensitive adhesives (e.g., rubber-based pressure-sensitive adhesives and acrylic pressure-sensitive adhesives) shown above as examples of the pressure-sensitive adhesive to be used in the heat-expandable pressure-sensitive adhesive layer. These pressure-sensitive adhesives can be used alone or in combination of two or more thereof. The pressure-sensitive adhesive to be used for forming the non-heat-expandable pressure-sensitive adhesive layer may contain known or common additives such as, e.g. a plasticizer, filler, surfactant, antioxidant, and tackifier.

The thickness of the non-heat-expandable pressure-sensitive adhesive layer is not particularly limited and can be suitably selected according to intended use, etc. The thickness thereof may be, for example, 300 µm or smaller (e.g., 1-300 µm, preferably 5-100 µm). For forming the non-heat-expandable pressure-sensitive adhesive layer, use can be made of the same methods as for the heat-expandable pressure-sensitive adhesive layer (e.g., the method in which a coating fluid is applied to a substrate and the method in which a coating fluid is applied to a separator to form a pressure-sensitive adhesive layer and this layer is transferred to a substrate). The non-heat-expandable pressure-sensitive adhesive layer may have either a single-layer or a multilayer constitution.

The heat-peelable pressure-sensitive adhesive sheet in the invention may be in the form of a double-faced adhesive sheet in which each side serves as an adhesive side. It is, however, preferred that it should be in the form of an adhesive sheet in which one side only serves as an adhesive side. Consequently, the heat-peelable pressure-sensitive adhesive sheetpreferablyisa heat-peelable pressure-sensitive adhesive sheet of the type which has a heat-expandable layer (inparticular, a heat-expandable pressure-sensitive adhesive layer) formed on one side of the substrate.

The heat-peelable pressure-sensitive adhesive sheet may be produced in the form of a roll or in the form of a stack of sheets. Namely, the heat-peelable pressure-sensitive adhesive sheet may be in the form of a sheet, tape, etc. The heat-peelable pressure-sensitive adhesive sheet in a roll state or formmaybe in the state or form in which the pressure-sensitive adhesive sheet has been wound up into a roll, with the pressure-sensitive adhesive side protected with a separator, or may be in the state or form in which the pressure-sensitive adhesive sheet has been wound up into a roll, with the pressure-sensitive adhesive side protected with a releasant layer (back coating layer) formed on the other side of the substrate.

### (Method of Thermal Release)

In the method of thermal adherend release of the invention, part of adherends adherent to the heat-peelable pressure-sensitive adhesive sheet (i.e., a heat-peelable pressure-sensitive adhesive sheet having a heat-expandable layer containing a foaming agent) are selectively released from the heat-peelable pressure-sensitive adhesive sheet after the heat-peelable pressure-sensitive adhesive sheet is partly heated in an atmosphere having a temperature of 50°C or higher at which the heat-expandable layer does not expand. Namely, it is important that the method of thermal adherend release of the invention should include at least a step in which the heat-peelable pressure-sensitive adhesive sheet is partly heated in an atmosphere having a temperature of 50°C or higher at which the heat-expandable layer does not expand to thereby selectively release part of the adherends adherent to the heat-peelable pressure-sensitive adhesive sheet (partial heating/release step).

By thus partly heating the heat-peelable pressure-sensitive adhesive sheet in an atmosphere having a temperature of 50°C or higher at which the heat-expandable layer does not expand, the time required for the foaming agent in the heat-expandable layer to expand or blow can be reduced and the release operation can be carried out more speedily. Although the atmosphere in which the heat-peelable pressure-sensitive adhesive sheet is partly heated to selectively release part of the adherends adherent to the heat-peelable pressure-sensitive adhesive sheet (i.e., the atmosphere for the partial heating/release step) has a temperature of 50°C or higher at which the heat-expandable layer does not expand, the temperature of the atmosphere for a step to be conducted before or after this partial heating/release step is not particularly limited.

The temperature of the atmosphere in which the heat-peelable pressure-sensitive adhesive sheet is partly heated (often referred to simply as "ambient temperature") is not particularly limited as long as it is a temperature in the range of from 50°C to below the peeling initiation temperature of the heat-peelable pressure-sensitive adhesive sheet. Namely, the "temperature at which the heat-expandable layer does not expand" can be a temperature lower than the "peeling initiation temperature of the heat-peelable pressure-sensitive adhesive sheet". Specifically, when the "peeling initiation temperature of the heat-peelable pressure-sensitive adhesive sheet" is expressed by "T₀", the ambient temperature for the partial heating of the heat-peelable pressure-sensitive adhesive sheet can be selected, for example, from temperatures which are not lower than 50°C and are not lower than (T₀-60°C) and below To, although it depends on the value of To. However, when the ambient temperature is a temperature higher than (T₀-10°C) and lower than To, there are cases where the heat-expandable layer of the heat-peelable pressure-sensitive adhesive sheet slightly expands or foams. It is therefore preferred that the ambient temperature be a temperature not lower than 50°C and not higher than (T₀-10°C), more preferably a temperature not lower than 50°C and not higher than (T₀-20°C). In particular, the ambient temperature preferably is a temperature which is not lower than 50°C and is (T₀-55°C) or higher and (T₀-45°C) or lower [e.g., a temperature which is not lower than 50°C and is about (T₀-50°C)]. More preferably, the ambient temperature is a temperature which is not lower than 50°C and is (T₀-45°C) or higher and (T₀-35°C) or lower [e.g., a temperature which is not lower than 50°C and is about (T₀-40°C)].

In the invention, in the case where the heat-expandable layer is a heat-expandable pressure-sensitive adhesive layer, the minimum heat treatment temperature capable of reducing the adhesive force of the heat-expandable pressure-sensitive adhesive layer, which contains a foaming agent (e.g., heat-expandable microspheres), to, for example, 10% or less of the initial adhesive force before heating can be regarded as the peeling initiation temperature of the heat-peelable pressure-sensitive adhesive sheet. Consequently, the peeling initiationtemperaturecanbedeterminedbymeasuringtheminimum heat treatment temperature capable of reducing the adhesive force of the heat-expandable pressure-sensitive adhesive layer, which contains a foaming agent (e.g., heat-expandable microspheres), to 10% or less of the initial adhesive force before heating. Specifically, the peeling initiation temperature can be determined in the following manner. A poly(ethylene terephthalate) film having a width of 20 mm and a thickness of 23 µm [trade name "Lumirror S10 #25" (manufactured by Toray Industries, Inc.); often referred to as "PET film"] is laminated to the surface of the heat-expandable pressure-sensitive adhesive layer, which contains a foaming agent (e.g., heat-expandable microspheres), of the heat-peelable pressure-sensitive adhesive sheet with a hand roller while avoiding air bubble inclusion to produce a test piece. At 30 minutes after the PET film laminating, the PET film is pulled away at a peel angle of 180° to measure the adhesive force of this test piece (measuring temperature, 23°C; pulling rate, 300 mm/min; peel angle, 180°). This adhesive force is taken as "initial adhesive force". Furthermore, test pieces produced by the method shown above are placed for 1 minute in respective circulating hot-air drying ovens each having a set temperature (heat treatment temperature), subsequently taken out of the circulating hot-air drying ovens, and then allowed to stand at 23°C for 2 hours. Thereafter, the PTF film of each test piece is pulled away at a peel angle of 180° to measure the adhesive force (measuring temperature, 23°C; pulling rate, 300 mm/min; peel angle 180°). This adhesive force is taken as "adhesive force after heat treatment". The minimum heat treatment temperature at which the adhesive force after heat treatment becomes 10% or less of the initial adhesive force is determined. This minimum heat treatment temperature can be regarded as the thermal-expansion initiation temperature of the foaming agent (e.g., heat-expandable microspheres) (thermal-expansion initiation temperature of the heat-expandable layer).

Even in the case where the heat-expandable layer is not a heat-expandable pressure-sensitive adhesive layer, the peeling initiation temperature of this heat-peelable pressure-sensitive adhesive sheet can be determined in the same manner as in the case described above in which the heat-expandable layer is a heat-expandable pressure-sensitive adhesive layer.

It is important that the partial heat treatment of the heat-peelable pressure-sensitive adhesive sheet be conducted in such a manner that those areas in the sheet which have adherends desired to be released, which are part of the adherends adherent to the heat-peelable pressure-sensitive adhesive sheet, are selectively heated. As a result of such partial heat treatment of the heat-peelable pressure-sensitive adhesive sheet, the areas thus heat-treated are selectively heated and the foaming agent (e.g., heat-expandable microspheres) in the heat-expandable layer in these areas expands (expanded areas). The adhesive force in these areas hence decreases or is lost, whereby the adherents adherent to these areas which have been selectively heat-treated can be released from the sheet. On the other hand, the areas apart from the areas which are heat-treated do not receive heat in the heat treatment and do not undergo the decrease in adhesive force attributable to expansion of the foaming agent (unexpanded areas). Consequently, the adherends adherent to these areas in the heat-peelable pressure-sensitive adhesive sheet retain the state of being adherent to the heat-peelable pressure-sensitive adhesive sheet.

Therefore, according to the method of thermal release of the invention, desired ones only of the adherends adherent to the heat-peelable pressure-sensitive adhesive sheet can be selectively and speedily (in a short time) released from the sheet by a simple operation.

The heater to be used for partly heating the heat-peelable pressure-sensitive adhesive sheet is not particularly limited as long as it can partly heat the heat-peelable pressure-sensitive adhesive sheet. It is, however, preferred to use a heater which is capable of partly heating the heat-peelable pressure-sensitive adhesive sheet according to the shape of each adherend to be released. Namely, it is preferred in the invention that a heater capable of partly heating the heat-peelable pressure-sensitive adhesive sheet according to the shape of each adherend to be released be used to selectively and efficiently heat those areas in the heat-peelable pressure-sensitive adhesive sheet in which the adherends to be released are adherent to thereby selectively release the adherends from the sheet.

It is important that the heat treatment temperature in the partial heating of the heat-peelable pressure-sensitive adhesive sheet be a temperature which is not lower than the peeling initiation temperature of the heat-expandable pressure-sensitive adhesive layer. In case where the heat treatment temperature is a temperature higher by generally at least 25°C than the peeling initiation temperature of the heat-expandable pressure-sensitive adhesive layer, the foaming agent (e.g., heat-expandable microspheres), which becomes expandable at the peeling initiation temperature, is undesirably apt to break. Because of this, for effectively causing thermal expansion while preventing the foaming agent from breaking, it is important that the heat treatment temperature generally be a temperature not higher by more than 25°C than the peeling initiation temperature of the heat-expandable pressure-sensitive adhesive layer although it depends on the kind of the foaming agent, etc. The heat treatment temperature may be higher by more than 25°C than the peeling initiation temperature of the heat-expandable pressure-sensitive adhesive layer. In this case, however, it is important that the heat treatment time be controlled so as to prevent the foaming agent from breaking. Consequently, when the peeling initiation temperature of the heat-expandable pressure-sensitive adhesive layer is expressed by To, the heat treatment temperature in the partial release of adherends adherent to the heat-expandable pressure-sensitive adhesive layer can be selected generally in the range of from To to below (T₀+25°C). From the standpoint of more rapid release, the heat treatment temperature may be selected from temperatures not lower than (T₀+25°C) and not higher than (T₀+100°C), preferably from temperatures not lower than (T₀+30°C) and not higher than (T₀+80°C), more preferably from temperatures not lower than (T₀+35°C) and not higher than (T₀+70°C).

The heat treatment time can be suitably selected according to the kind of the heat-peelable pressure-sensitive adhesive sheet, kind of the foaming agent, properties of the adherends, heat treatment temperature, heating method, etc.

When the heat-peelable pressure-sensitive adhesive sheet is partly heated, it can be heated from at least one side selected between the side to which adherends are adherent (referred to as "adherend side") and the side opposite thereto (the side to which adherends are not adherent; often referred to as "non-adherend side"). Consequently, the heat-peelable pressure-sensitive adhesive sheet may be heated from either of the adherend side and the non-adherend side (the side to which adherends are not adherent), or may be heated from each of the adherend side and the non-adherend side. In the case where the heat-peelable pressure-sensitive adhesive sheet is heated from each of the adherend side and the non-adherend side, the sheet may be heated simultaneously from both of the adherend side and the non-adherend side. Alternatively, the sheet may be heated first from either of the adherend side and the non-adherend side and then from the other side.

In the invention, the adherends adherent to the heat-peelable pressure-sensitive adhesive sheet may be adherends which have been separately bonded to the heat-peelable pressure-sensitive adhesive sheet. However, the adherends preferably are ones formed by cutting an adherend adherent to the heat-peelable pressure-sensitive adhesive sheet into pieces. Consequently, the method of thermal adherend release of the invention preferably comprises a step in which an adherend adherent to the heat-peelable pressure-sensitive adhesive sheet is cut into pieces (cutting step) and a step in which the heat-peelable pressure-sensitive adhesive sheet is partly heated in an atmosphere having a temperature of 50°C or higher at which the heat-expandable layer does not expand to thereby selectively release part of the cut pieces (partial heating/release step).

For cutting an adherend adherent to the heat-peelable pressure-sensitive adhesive sheet into pieces in the cutting step, any cutting method may be used without particular limitations. A suitable method can be selected according to the kind of the adherend, etc. For example, in the case where the adherend is a silicon wafer as in the case which will be shown later, it is preferred to employ dicing as the cutting.

In the invention, since part of the adherends (e.g., cut pieces formed by cutting) adherent to the heat-peelable pressure-sensitive adhesive sheet are selectively heated in the partial heating/release step, a cutting operation in which an adherend which has not undergone cutting is cut into pieces can be conducted simultaneously with this heat treatment. Namely, the partial heating/release step can be conducted simultaneously with the cutting step. In other words, the cutting step and the partial heating/release step can be conducted as a united step. It is a matter of course that a step in which after the adherends, e.g., cut pieces, are partly heat-treated, the heat-treated adherends, e.g., cut pieces, are separated and recovered from the heat-peelable pressure-sensitive adhesive sheet (separation/recovery step) also can be conducted as a step united with the partial heating/release step. Consequently, the cutting step and the separation/recovery step can be conducted simultaneously with the partial heating/release step. Specifically, the cutting step and the partial heating/release step may be conducted as a united step, or the partial heating/release step and the separation/recovery step may be conducted as a united step. Furthermore, the cutting step, partial heating/release step, and separation/recovery step may be conducted as a united step. By thus conducting the cutting step and the separation/recovery step simultaneously with the partial heating/release step, these steps can be performed extremely efficiently and productivity can be greatly improved.

When one adherend is handled, there is an order in conducting those steps. In this case, it is important to conduct the cutting step, partial heating/release step, and separation/recovery step in this order.

In the case where the partial heating/release step is conducted simultaneously with other steps (e.g., the cutting step and the separation/recovery step) as described above, the latter steps also are performed in the same atmosphere as the partial heating/release step (i.e., in an atmosphere having a temperature of 50°C or higher at which the heat-expandable layer does not expand).

It is a matter of course that the method of thermal adherend release may be conducted in the following manner. One adherend is subjected to a cutting operation in the cutting step, subsequently to a heat treatment in the partial heating/release step, and then to a separation/recovery operation in the separation/recovery step. Thereafter, another adherend is subjected to a cutting operation in the cutting step, subsequently to a heat treatment in the partial heating/release step, and then to a separation/recovery operation in the separation/recovery step. This procedure is repeated to thereby conduct the cutting operation, heat treatment, and separation/recovery operation on the heat-peelable pressure-sensitive adhesive sheet.

### (Apparatus for Thermal Adherend Release)

The apparatus for thermal adherend release of the invention is an apparatus to be used for separating adherends from the heat-peelable pressure-sensitive adhesive sheet described above (i.e., a heat-peelable pressure-sensitive adhesive sheet having a heat-expandable layer containing a foaming agent). This apparatus has a heating part for partly heating the heat-peelable pressure-sensitive adhesive sheet in an atmosphere having a temperature of 50°C or higher at which the heat-expandable layer does not expand to thereby selectively release part of the adherends. As this apparatus for thermal adherend release can be used, for example, an apparatus for thermal adherend release such as that shown in Fig. 2. Fig. 2 is a diagrammatic view showing part of one embodiment of the apparatus for thermal adherend release of the invention. In Fig. 2, numeral 6 denotes a heating/release part in the apparatus for thermal adherend release, 7 a heating part, 7a a surface part of the heating part 7, 8 a suction nozzle, 9 a fixing ring, 10 a die bonder, 11 a heat source, 12 a heat-peelable pressure-sensitive adhesive sheet, 13 a heat-expandable pressure-sensitive adhesive layer, 13a an unexpanded area in the heat-expandable pressure-sensitive adhesive layer 13, 13b an expanded area in the heat-expandable pressure-sensitive adhesive layer 13, 14 a substrate, 15 an adherend, and 15a an adherend released.

Fig. 2 shows the heating/release part 6 of an apparatus for thermal adherend release. A heat-peelable pressure-sensitive adhesive sheet 12 to which adherends 15 are adherent is in the state of being fixed with fixing rings 9. This heat-peelable pressure-sensitive adhesive sheet 12 has a constitution comprising a substrate 14 and a heat-expandable pressure-sensitive adhesive layer 13 formed thereon. The surface part 7a of the heating part 7 is brought into contact with the heat-peelable pressure-sensitive adhesive sheet 12 (front side of the heat-expandable pressure-sensitive adhesive layer 13 or back side of the substrate 14), whereby the heat-peelable pressure-sensitive adhesive sheet 12 is partly heated and the foaming agent present in this selectively heated area in the heat-expandable layer (heat-expandable pressure-sensitive adhesive layer in Fig. 2) expands or blows. The heat-expandable layer hence expands partly and that area in the pressure-sensitive adhesive side which corresponds to the expanded part deforms to have surface irregularities, resulting in a decrease in the area of adhesion between the pressure-sensitive adhesive side and the corresponding adherend 15. As a result, the adhesive force between the pressure-sensitive adhesive side which has deformed to have surface irregularities and the adherend 15 decreases. Thereafter, this adherend 15 is sucked by a suction nozzle 8 and released from the heat-peelable pressure-sensitive adhesive sheet 12. Thus, among adherends 15 adherent to the pressure-sensitive adhesive side, an adherend 15a as part of these adherends is released from the heat-peelable pressure-sensitive adhesive sheet 12.

The heating/release part 6 in this apparatus for thermal adherend release is a part for partly heating a heat-peelable pressure-sensitive adhesive sheet and separating an adherend (i.e., a part for conducting the partial heating/release step) . The atmosphere in this part 6 is regulated so as to have a temperature of 50°C or higher at which the heat-expandable layer of the heat-peelable pressure-sensitive adhesive sheet 12 does not expand. Namely, in the apparatus for thermal adherend release, desired areas in the heat-peelable pressure-sensitive adhesive sheet are selectively heated, in preparation for release, in an atmosphere having a temperature of 50°C or higher at which the heat-expandable layer of the heat-peelable pressure-sensitive adhesive sheet does not expand.

In Fig. 2, fixing rings 9 are used as a fixing part for fixing the heat-peelable pressure-sensitive adhesive sheet 12. The heating part 7 has a shape which enables the heating part 7 to heat the heat-peelable pressure-sensitive adhesive sheet according to the shape of each adherend to be released. The heating part 7 and the suction nozzle 8 are movable in horizontal and vertical directions as shown by the arrows.

In Fig. 2, a heat-peelable pressure-sensitive adhesive sheet 12 having a constitution comprising a substrate 14 and a heat-expandable pressure-sensitive adhesive layer 13 formed thereonisused. However, anyheat-peelablepressure-sensitive adhesive sheet having a constitution comprising a heat-expandable layer containing a foaming agent may be used. For example, the heat-peelable pressure-sensitive adhesive sheet 1 shown in Fig. 1 may be used.

As described above, the apparatus for thermal adherend release of the invention is an apparatus for separating adherends from a heat-peelable pressure-sensitive adhesive sheet having a heat-expandable layer containing a foaming agent, and has at least a heating part for partly heating the heat-peelable pressure-sensitive adhesive sheet in an atmosphere having a temperature of 50°C or higher at which the heat-expandable layer does not expand to thereby selectively release part of the adherends. It is important that the heating part employ a heating technique capable of sufficiently heating the heat-peelable pressure-sensitive adhesive sheet. Specifically, examples of heating techniques usable in the heating part include known heating techniques such as heating with an electric heater, dielectric heating, magnetic heating, and heating with electromagnetic waves such as infrared rays (e.g., near infrared rays, mid infrared rays, or far infrared rays). The heating of the heat-peelable pressure-sensitive adhesive sheet by the heating part may be conducted either directly or indirectly.

The material of the surface part of the heating part can be suitably selected according to the heating technique. For example, in the case where heating with an electric heater is employed as a heating technique, the surface part of the heating part is preferably constituted of a material having a high thermal conductivity. For example, the surface part may be constituted of a combination of a metallic material and a heat insulator (e.g., asbestos). Furthermore, a combination with an elastic material such as, e.g., a rubber may be used for the purpose of enhancing the tightness of contact between the heating part and adherends. For example, when the surface part of the heating part is constituted of a combination of an elastic material (heat-conductive elastic material) such as a rubber, a metallic material, and a heat insulator, the heat-expandable layer of the heat-peelable pressure-sensitive adhesive sheet can be more rapidly expanded and adherends can be separated more quickly.

The shape and size of the heating part can be suitably designed according to the shape and size of each adherend to be released. When the heating part corresponding to the shape of an adherend to be released is used to heat that area in the heat-peelable pressure-sensitive adhesive sheet in which the adherend is adherent, then the heated area in the heat-peelable pressure-sensitive adhesive sheet, which was in an unexpanded state before the heating (unexpanded area), expands (expanded area). As a result, only part of the adherends is deprived of adhesive force. Thus, the adherend to be release can be selectively released and picked up with, e.g., a suction nozzle.

The period of heating with the heating part can be suitably determined according to the kind of the heat-peelable pressure-sensitive adhesive sheet, kind of the foaming agent, properties of the adherend, heating technique, etc. as stated above, and cannot be unconditionally specified. Care should be taken not to heat for too long a period because prolonged heating may result in cases where not only the adherend desired to be released but also ones which are not desired to be released undergo release due to the thermal conductivity of the heat-peelable pressure-sensitive adhesive sheet heated and of the adherends, etc.

The heating part can be disposed on at least one side of the heat-peelable pressure-sensitive adhesive sheet selected between the adherend side and the side opposite thereto (non-adherend side). Consequently, the heat-peelable pressure-sensitive adhesive sheet may be heated from either of the adherend side and the non-adherend side, or may be heated from each of the adherend side and the non-adherend side. In the case where the heat-peelable pressure-sensitive adhesive sheet is heated from each of the adherend side and the non-adherend side, desired areas in the heat-peelable pressure-sensitive adhesive sheet may be heated simultaneously from both of the adherend side and the non-adherend side, or may be heated separately from both sides.

This heating part preferably is movable in a horizontal direction and/or a vertical direction. When the heating part is movable in three-dimensional directions, desired areas in the heat-peelable pressure-sensitive adhesive sheet can be selectively heated efficiently.

The apparatus for thermal adherend release described above has a fixing part for fixing the heat-peelable pressure-sensitive adhesive sheet. This fixing part is optional. It is important that the fixing part employ a fixing mechanism which prevents the adherends from suffering, e.g., positional shifting on the heat-peelable pressure-sensitive adhesive sheet during a processing, release operation, etc. and can sufficiently fix the adherends.

Specifically, a fixing mechanism for the fixing part can be suitably selected according to the kind of the adherends, etc. For example, a known fixing mechanism such as, e.g., fixing with a ring frame (fixing rings), fixing with a pedestal, or fixing by suction can be used. Like the heating part, the fixing part also may be movable in a horizontal direction and/or a vertical direction.

In the apparatus for thermal adherend release, after the heat-peelable pressure-sensitive adhesive sheet is partly heat-treated to reduce adhesive force so that a desired adherend adherent to the heat-peelable pressure-sensitive adhesive sheet can be released, the adherend is separated and recovered from the heat-peelable pressure-sensitive adhesive sheet. For this separation/recovery, the apparatus further has a suction nozzle as an adherend separation/recovery part. The adherend separation/recovery part, e.g., a suction nozzle, is optional. The adherend separation/recovery part is not particularly limited as long as it is capable of separating and recovering adherends from the heat-peelable pressure-sensitive adhesive sheet. However, a suction part which separates and recovers adherends by means of suction is preferred, and it is especially preferred to use a suction nozzle. The suction nozzle is not particularly limited, and can be suitably selected from known suction nozzles. It is a matter of course that the suction nozzle can hold an adherend on the nozzle head by means of suction and thereby separate and recover the adherend from the heat-peelable pressure-sensitive adhesive sheet. Like the heating part, the adhered separation/recovery part also is preferably movable in a horizontal direction and/or a vertical direction (especially in three-dimensional directions).

Furthermore, in the apparatus for thermal adherend release, the atmosphere in the heating/release part, which performs the partial heating/release step, is regulated so as to have a temperature of 50°C or higher at which the heat-expandable layer of the heat-peelable pressure-sensitive adhesive sheet does not expand. By thus regulating the atmosphere in the heating/release part, which partly heats the heat-peelable pressure-sensitive adhesive sheet and releases an adherend therefrom, so as to have a temperature of 50°C or higher at which the heat-expandable layer of the heat-peelable pressure-sensitive adhesive sheet does not expand, the heat-peelable pressure-sensitive adhesive sheet can be kept in the state of being heated at a temperature at which the heat-expandable layer does not thermally expand. Because of this, when the heat-peelable pressure-sensitive adhesive sheet is partly heated, it can be rapidly heated to a temperature at which the heat-expandable layer begins to thermally expand, whereby the time required for the foaming agent in the heat-expandable layer to expand or blow can be effectively reduced. Consequently, when the heat-peelable pressure-sensitive adhesive sheet is partly heated for release, the rate of release can be heightened.

In the invention, the apparatus for thermal adherend release is not particularly limited in ambient temperature as long as the atmosphere in the heating/release part in the apparatus has a temperature of 50°C or higher at which the heat-expandable layer of the heat-peelable pressure-sensitive adhesive sheet does not expand. Consequently, for example, either the heating/release part only or that part of the apparatus for thermal adherend release which includes the heating/release part may be disposed in a box, room, or the like in which the atmosphere has a temperature of 50°C or higher at which the heat-expandable layer of the heat-peelable pressure-sensitive adhesive sheet does not expand. Alternatively, the whole apparatus for thermal adherend release may be disposed in a box, room, or the like in which the atmosphere has a temperature of 50°C or higher at which the heat-expandable layer of the heat-peelable pressure-sensitive adhesive sheet does not expand.

When at least the heating/release part of the apparatus for thermal adherend release is disposed in a device, e.g., a die bonder, in which the atmosphere has a temperature of 50°C or higher at which the heat-expandable layer of the heat-peelable pressure-sensitive adhesive sheet does not expand, with the heating/release part kept in a closed state or kept in a state as close to a closed state as possible, then the temperature of the atmosphere in the heating/release part can be even more highly stabilized. Because of this, the heat-peelable pressure-sensitive adhesive sheet can be regulated so as to have a constant temperature of 50°C or higher at which the heat-expandable layer of the heat-peelable pressure-sensitive adhesive sheet does not expand. As a result, when the heat-peelable pressure-sensitive adhesive sheet is partly heated for release, the rate of release can be heightened even more.

For regulating the atmosphere in a box, a room, or the like so as to have a temperature of 50°C or higher at which the heat-expandable layer of the heat-peelable pressure-sensitive adhesive sheet does not expand, a heat source is used. This heat source is not particularly limited. For example, use can be made of an electric heater, heat source in dielectric heating, heat source in magnetic heating, heat source in electromagnetic heating (e.g., infrared heating such as near infrared heating, mid infrared heating, or far infrared heating), air conditioner, gas-fired space heater with a fan, kerosene space heater, or oil space heater.

The apparatus for thermal adherend release of the invention may have a cutting part in which an adherend adherent to the heat-peelable pressure-sensitive adhesive sheet is cut into pieces. Namely, the apparatus for thermal adherend release may have: a cutting part by which an adherend adherent to a heat-peelable pressure-sensitive adhesive sheet having a heat-expandable layer containing a foaming agent is cut into pieces; and a heating part for partly heating the heat-peelable pressure-sensitive adhesive sheet in an atmosphere having a temperature of 50°C or higher at which the heat-expandable layer does not expand to thereby selectively release part of the cut pieces. Such a cutting part is optional. The cutting part is not particularly limited as long as it can cut an adherend adherent to the heat-peelable pressure-sensitive adhesive sheet into pieces. A suitable cutting part can be selected according to the kind of the adherend, size of the cut pieces, etc. In the case where the adherend is a silicon wafer as in the case shown later, the cutting part preferably is a dicing part which performs dicing.

In this apparatus for thermal adherend release of the invention, a cutting operation and a heat treatment on the heat-peelable pressure-sensitive adhesive sheet and optionally a separation/recovery operationmaybe conducted in the following manner. An adherend adherent to the heat-peelable pressure-sensitive adhesive sheet is subjected to a cutting operation by the cutting part, and a heat treatment with the heating part is then conducted with respect to desired part of the cut pieces resulting from the cutting. According to need, a separation/recovery operation by the adherend separation/recovery part is further conducted. Thereafter, the same operations are repeatedly conducted for other adherends.

In particular, since the heating part is used to partly heat the heat-peelable pressure-sensitive adhesive sheet for separating cut pieces from the heat-peelable pressure-sensitive adhesive sheet in the invention, a partial cutting operation can be conducted simultaneously with a partial heat treatment when the cutting by the cutting part is conducted partly. Specifically, the procedure is as follows. First, a desired one of adherends adherent to the heat-peelable pressure-sensitive adhesive sheet is cut into pieces by the cutting part and, thereafter, a next desired adherend is cut into pieces by the cutting part. Simultaneously with this cutting operation, partial heating by the heating part can be conducted in order to selectively release part of the cut pieces obtained by the first cutting. Thus, the cutting operation by the cutting part and the heat treatment with the heating part for separating cut pieces can be conducted highly efficiently and productivity can be greatly improved. Although the heating/separation operation is, of course, followed by the separation and recovery of cut pieces by the adherend separation/recovery part, this separation/recovery of cut pieces by the adherend separation/recovery part (cut piece separation/recovery part) also can be partly conducted simultaneously with the heat treatment. Thus, a cutting operation, heating/release operation, and separation/recovery operation, for example, can be simultaneously conducted.

In the case where a cutting operation, heat treatment, and separation/recovery operation are simultaneously conducted in the manner described above, it is important that the cutting part for conducting cutting, the heating part for conducting heating, and the cut piece separation/recovery part (corresponding to the adherend separation/recovery part in Fig. 2) for conducting separation/recovery be movable in a horizontal direction and/or a vertical direction (especially in three-dimensional directions).

As described above, with the apparatus for thermal adherend release of the invention, it is possible to conduct a cutting operation, a heat treatment, and optionally a separation/recovery operation in the single apparatus. In this apparatus for thermal adherend release, the cutting part, heating part, and adherend separation/recovery part (cut piece separation/recovery part) as an optional component may be disposed in separate places or disposed movably, or may be disposed in the same place. In the case where the cutting part, heating part, and adherend separation/recovery part (cut piece separation/recovery part) are disposed in separate places or movably, a cutting operation, heat treatment, and separation/recovery operation can be simultaneously conducted. On the other hand, in the case where these parts are disposed in the same place, a cutting operation, heat treatment, and separation/recovery operation can be repeatedly conducted in this order.

### (Adherends)

The adherends are not particularly limited as long as they are to be bonded to the heat-peelable pressure-sensitive adhesive sheet so as to be subj ected to, e. g. , various processings. Examples of the adherends include electronic part precursors, such as semiconductor wafers (e.g., silicon wafers) and semiconductor chips, and electronic parts or circuit boards employing an electronic part precursor (e.g., electronic parts employing a silicon wafer as a substrate).

### EXAMPLES

The invention will be explained below in more detail by reference to Examples, but the invention should not be construed as being limited by these Examples.

### EXAMPLE 1

A nickel foil (often referred to as "Ni foil") having dimensions of 150 mm x 150 mm (thickness, 100 µm) was bonded to a heat-peelable pressure-sensitive adhesive tape (fixed with fixing rings) constituted of a polyester substrate (100 µm thick) and a heat-expandable pressure-sensitive adhesive layer beginning to decrease in adhesive force at 90°C; the foil was bonded to the heat-expandable pressure-sensitive adhesive layer side. This Ni foil was cut into 5-mm squares. Thus, a heat-peelable pressure-sensitive adhesive tape having cut Ni foil pieces adherent thereto was obtained.

A heating part was prepared which comprised an electric heater and, disposed on the head thereof, a stainless-steel (SUS304) plate which was 5 mm square and 2 mm thick and a heat-conductive rubber sheet (5 mm square and 1 mm thick).

The heat-peelable pressure-sensitive adhesive tape (fixed with fixing rings) having cut Ni foil pieces adherent thereto was allowed to stand for 3 minutes in an atmosphere heated at 50 °C by near infrared irradiation. In this atmosphere, the heating part was heated with the electric heater so that the temperature of the rubber sheet part (outermost head part) was elevated to 150°C, and that area in the pressure-sensitive adhesive tape which had a cut Ni foil piece desired to be released, of the cut Ni foil pieces formed by the cutting operation, was pressed from the back side thereof with the heating part whose head had been heated at 150°C to thereby thermally expand that area in the heat-expandable pressure-sensitive adhesive layer. After the adhesive force of the heat-expandable pressure-sensitive adhesive layer had become almost nil, a suction nozzle was used to release the cut Ni foil piece from the heat-peelable pressure-sensitive adhesive tape by means of suction and recovered. The time required for separating the cut Ni foil piece through heating with the heating part without breaking the cut Ni foil pieces adherent to the heat-expandable pressure-sensitive adhesive layer (time required for release) was 1.5 seconds as shown in Table 1.

### EXAMPLE 2

A silicon wafer having a diameter of 6 inches (150 µm thick) was bonded, while avoiding air bubble inclusion, to a heat-peelable pressure-sensitive adhesive tape constituted of a polyester substrate (100 µm thick), a heat-expandable pressure-sensitive adhesive layer beginning to decrease in adhesive force at 120°C and formed on one side of the polyester substrate, and a pressure-sensitive adhesive layer formed on the other side of the polyester substrate for fixing to a pedestal; the wafer was bonded to the heat-expandable pressure-sensitive adhesive layer side. That side of this pressure-sensitive adhesive tape which had the pressure-sensitive adhesive layer for fixing to a pedestal (the adhesive side opposite to the silicon wafer side) was applied to a flat pedestal made of stainless steel. The silicon wafer was diced into 3 mm squares. Thus, a heat-peelable pressure-sensitive adhesive tape having cut silicon wafer pieces adherent thereto was obtained.

A heating part was prepared which comprised an electric heater and, disposed on the head thereof, a stainless-steel (SUS304) plate which was 3 mm square and 2 mm thick and a heat-conductive rubber sheet (3 mm square and 1 mm thick).

The heat-peelable pressure-sensitive adhesive tape having cut silicon wafer pieces adherent thereto was allowed to stand for 3 minutes in an atmosphere heated at 90°C by near infrared irradiation. In this atmosphere, the heating part was heated with the electric heater so that the temperature of the rubber sheet part (outermost head part) was elevated to 160°C, and that area in the pressure-sensitive adhesive tape which had a cut silicon wafer piece desired to be released, of the cut silicon wafer pieces formed by the cutting operation, was pressed from the silicon wafer side thereof with the heating part whose head had been heated at 160°C to thereby thermally expand that area in the heat-expandable pressure-sensitive adhesive layer. After the adhesive force of the heat-expandable pressure-sensitive adhesive layer had become almost nil, a suction nozzle was used to release the cut silicon wafer piece from the heat-peelable pressure-sensitive adhesive tape by means of suction and recovered. The time required for separating the cut silicon wafer piece through heating with the heating part without breaking the cut silicon wafer pieces adherent to the heat-expandable pressure-sensitive adhesive layer (time required for release) was 1.8 seconds as shown in Table 1.

### COMPARATIVE EXAMPLE 1

A cut Ni foil piece was separated and recovered from a heat-peelable pressure-sensitive adhesive tape in the same manner as in Example 1, except that the heat-peelable pressure-sensitive adhesive tape (fixed with fixing rings) having cut Ni foil pieces adherent thereto was allowed to stand in a 23°C atmosphere for 3 minutes, and that in this atmosphere, that area in the pressure-sensitive adhesive tape which had a cut Ni foil piece desired to be released, of the cut Ni foil pieces formed by the cutting operation, was pressed from the back side thereof with the heating part whose head had been heated at 150°C to thereby thermally expand that area in the heat-expandable pressure-sensitive adhesive layer. The time required for separating the cut Ni foil piece through heating with the heating part without breaking the cut Ni foil pieces adherent to the heat-expandable pressure-sensitive adhesive layer (time required for release) was 2.6 seconds as shown in Table 1.

### COMPARATIVE EXAMPLE 2

A cut silicon wafer piece was separated and recovered from a heat-peelable pressure-sensitive adhesive tape in the same manner as in Example 2, except that the heat-peelable pressure-sensitive adhesive tape having cut silicon wafer pieces adherent thereto was allowed to stand in a 23°C atmosphere for 3 minutes, and that in this atmosphere, that area in the pressure-sensitive adhesive tape which had a cut silicon wafer piece desired to be released, of the cut silicon wafer pieces formed by the cutting operation, was pressed from the silicon wafer side thereof with the heating part whose head had been heated at 160°C to thereby thermally expand that area in the heat-expandable pressure-sensitive adhesive layer. The time required for separating the cut silicon wafer piece through heating with the heating part without breaking the cut silicon wafer pieces adherent to the heat-expandable pressure-sensitive adhesive layer (time required for release) was 2.8 seconds as shown in Table 1.

**Table 1**

| | Example | | Comparative Example | |
|---|---|---|---|---|
| | 1 | 2 | 1 | 2 |
| Time required for release (sec) | 1.5 | 1.8 | 2.6 | 2.8 |

Table 1 shows the following. When adherends such as a cut Ni foil piece and a cut silicon wafer piece were thermally released from the heat-peelable pressure-sensitive adhesive tape, the time required for the heat-expandable layer (e.g., heat-expandable pressure-sensitive adhesive layer) or foaming agent (e.g., heat-expandable microspheres) to expand and thereby eliminate the adhesive force of the heat-expandable layer could be effectively reduced by regulating the atmosphere for the thermal release so as to have a temperature of 50°C or higher at which the heat-expandable layer did not expand. Furthermore, part of the adherends adherent to the heat-expandable pressure-sensitive adhesive tape can be selectively and more rapidly released from the heat-expandable pressure-sensitive adhesive tape by partly heating the pressure-sensitive adhesive tape.

While the invention has been described in detail and with reference to specific embodiments thereof, it will be apparent to one skilled in the art that various changes and modifications can be made therein without departing from the spirit and scope thereof.

The present application is based on Japanese Patent Application 2004-125331, filed on April 21, 2004, and the entire disclosure thereof are incorporated herein by reference in its entirety.

## Claims

1. A method of thermal adherend release, wherein part of adherends adherent to a heat-peelable pressure-sensitive adhesive sheet having a heat-expandable layer containing a foaming agent are selectively released from the pressure-sensitive adhesive sheet,
wherein the method comprises partly heating the heat-peelable pressure-sensitive adhesive sheet in an atmosphere having a temperature of 50°C or higher at which the heat-expandable layer does not expand to thereby selectively release the adherends.

2. The method of thermal adherend release according to claim 1, wherein the foaming agent comprises heat-expandable microspheres.

3. The method of thermal adherend release according to claim 1 or 2, wherein a heater capable of partly heating the heat-peelable pressure-sensitive adhesive sheet according to the shape of each adherend to be released is used to heat those areas in which the adherends to be released are adherent in the heat-peelable pressure-sensitive adhesive sheet to thereby selectively release the adherends.

4. The method of thermal adherend release according to any one of claims 1 to 3, wherein the heat-peelable pressure-sensitive adhesive sheet is heated from at least one side selectedbetween the side to which the adherends are adherent and the side opposite thereto.

5. A method of thermal adherend release, wherein part of adherends adherent to a heat-peelable pressure-sensitive adhesive sheet having a heat-expandable layer containing a foaming agent are selectively released from the pressure-sensitive adhesive sheet,
wherein the method comprises a step in which an adherend adherent to the heat-peelable pressure-sensitive adhesive sheet is cut into pieces, and a step in which the heat-peelable pressure-sensitive adhesive sheet is partly heated in an atmosphere having a temperature of 50°C or higher at which the heat-expandable layer does not expand to thereby selectively release part of the cut pieces.

6. An apparatus for thermal adherend release, which is for separating adherends from a heat-peelable pressure-sensitive adhesive sheet having a heat-expandable layer containing a foaming agent,
wherein the apparatus has a heating part for partly heating the heat-peelable pressure-sensitive adhesive sheet in an atmosphere having a temperature of 50°C or higher at which the heat-expandable layer does not expand to thereby selectively release part of the adherends.

7. The apparatus for thermal adherend release according to claim 6, wherein the heating part has a shape which enables the heating part to heat the heat-peelable pressure-sensitive adhesive sheet according to the shape of each adherend to be released.

8. The apparatus for thermal adherend release according to claim 6 or 7, which has the heating part disposed on at least one side of the heat-peelable pressure-sensitive adhesive sheet selected between the side to which the adherends are adherent and the side opposite thereto.

9. The apparatus for thermal adherend release according to any one of claims 6 to 8, wherein the heating part is movable in a horizontal direction and/or a vertical direction.

10. The apparatus for thermal adherend release according to any one of claims 6 to 9, which comprises: a cutting part by which an adherend adherent to a heat-peelable pressure-sensitive adhesive sheet having a heat-expandable layer containing a foaming agent is cut into pieces; and a heating part for partly heating the heat-peelable pressure-sensitive adhesive sheet in an atmosphere having a temperature of 50°C or higher at which the heat-expandable layer does not expand to thereby selectively release part of the cut pieces.
